# FASCICULE DE BREVET EUROPEEN

(11) **EP 0 996 129 B1**
(45) Date de publication et mention de la délivrance du brevet: **07.05.2003**
(21) Numéro de dépôt: 99410141.8
(22) Date de dépôt: 21.10.1999
(51) Int. Cl.: G11C 11/401

(54) **Cellule mémoire DRAM**
DRAM-Speicherzelle
DRAM memory cell

(30) Priorité: 23.10.1998 FR 9813546
(43) Date de publication de la demande: 26.04.2000
(73) Titulaire: STMicroelectronics S.A., 92120 Montrouge (FR); FRANCE TELECOM, 75015 Paris (FR)
(72) Inventeur: Jaouen, Hervé, 38240 Meylan (FR); Ferrant, Richard, 38330 Saint Ismier (FR)
(74) Mandataire: de Beaumont, Michel

(56) Documents cités:
- US-A- 5 243 209
- US-A- 5 393 998
- US-A- 5 739 576
- US-A- 5 801 412

## Description

La présente invention concerne, de façon générale, les cellules mémoire. Plus particulièrement, la présente invention concerne des cellules mémoire de type dynamique à accès aléatoire (DRAM) compatibles avec un procédé de fabrication d'un dispositif incorporant une telle mémoire et des composants CMOS.

De façon classique, une mémoire DRAM se présente sous la forme d'une matrice de colonnes et de rangées aux intersections desquelles se trouvent des cellules mémoire constituées d'un élément mémoire, typiquement un condensateur, et d'un commutateur de commande de cet élément mémoire, typiquement un transistor MOS.

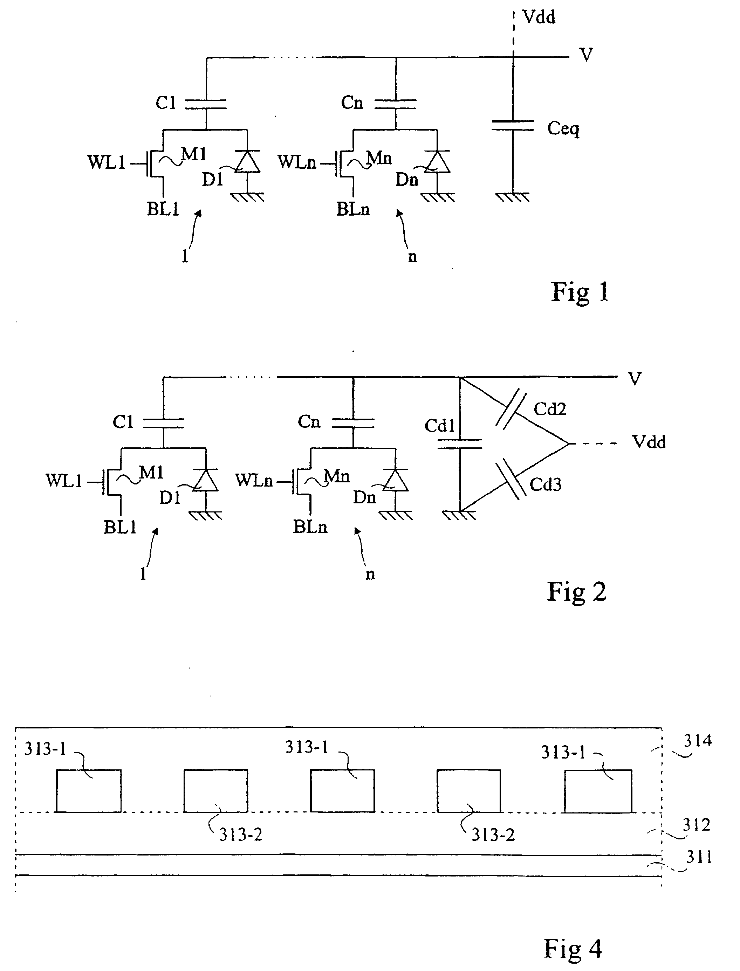

La figure 1 représente une partie du schéma équivalent d'une telle mémoire. Plus précisément, la figure 1 illustre le schéma électrique équivalent d'une des rangées de la mémoire. Parmi les n cellules de la rangée considérée, on a représenté les première et dernière cellules mémoire 1 et n. Les cellules 1 et n sont respectivement constituées d'un condensateur C1, Cn dont une première électrode est connectée au drain d'un transistor de commande respectif M1, Mn et: dont une deuxième électrode est commune aux n cellules. La grille du transistor M1, Mn est reliée à une ligne de mot WL1, WLn de la cellule considérée et sa source est reliée à une ligne de bit BL1, BLn de la cellule considérée. Les jonctions drain/substrat de chacun des transistors M1, Mn, représentées en figure 1 par des diodes D1, Dn, assurent le maintien de l'information dans l'élément mémoire C1, Cn quand la cellule considérée n'est pas adressée en écriture.

Une matrice mémoire classique comporte un nombre n de rangées et un nombre m de colonnes. On considérera ci-après le cas simple où n et m sont égaux, par exemple n=m=1024. Alors, pour chacune des rangées, identiques à celle représentée en figure 1, les n-1 autres rangées de n cellules mémoire constituent un condensateur équivalent Ceq dont une première électrode est commune à l'électrode commune des n cellules mémoire de la rangée sélectionnée, et dont une deuxième électrode est ramenée à la masse.

L'électrode commune aux n éléments Cl, Cn de la rangée considérée et au condensateur Ceq est connectable à une première alimentation susceptible de la polariser à un potentiel d'écriture Vdd quand une donnée doit être mémorisée dans un élément mémoire.

Enfin, hors les périodes d'écriture, l'électrode commune aux n éléments Cl, Cn de la rangée considérée et au condensateur Ceq est préchargée par une alimentation continue V. Le potentiel de précharge V peut avoir une valeur quelconque, supérieure au potentiel de masse du circuit et inférieure au potentiel haut, d'écriture, Vdd, mais doit être très stable. On choisit typiquement une valeur égale à Vdd/2, afin de diminuer les risques de claquage de l'oxyde inter-électrodes lors d'un passage au potentiel de masse lors de la désélection de la rangée.

Un inconvénient de ce type de structure réside en ce que lors de la variation de la charge des condensateurs Cl, Cn, il apparaît un appel/renvoi de courant relativement élevé, par exemple de l'ordre de 5 mA, pendant une durée relativement importante, de l'ordre de 3 ns, pour une mémoire de 1 mégabit. Il apparaît alors aux bornes de la rangée considérée une différence de tension relativement importante, par exemple de l'ordre de 0,25 V. Alors, compte tenu du grand nombre de condensateurs qui peuvent être chargés en même temps, un tel phénomène peut affecter les alimentations qui doivent supporter un tel appel/renvoi. De même, la masse du circuit, commune à tous les éléments, est affectée par de tels renvois. À l'extrême, la propagation de telles perturbations peut affecter un ou plusieurs quelconques points mémoire et provoquer la corruption des données mémorisées.

Un objet de la présente invention est de proposer une mémoire DRAM dans laquelle les alimentations et la masse soient protégées des variations de charge des éléments mémoire.

Pour atteindre cet objet, la présente invention prévoit une mémoire dynamique à accès aléatoire réalisée sous forme monolithique dont les cellules comportent chacune un transistor MOS et un condensateur dont une deuxième électrode est commune à toutes les cellules d'une même rangée et est recouverte d'un isolant, caractérisée en ce que l'isolant est revêtu d'éléments conducteurs indépendants répartis sur un même plan horizontal, deux éléments voisins étant polarisés à des niveaux respectifs haut et bas.

Selon un mode de réalisation de la présente invention, le potentiel bas est le potentiel de référence du circuit dans lequel est formée la cellule.

Selon un mode de réalisation de la présente invention, le potentiel haut est le potentiel d'écriture de la cellule mémoire.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le schéma équivalent d'une rangée d'une matrice mémoire DRAM classique ;
la figure 2 représente le schéma équivalent d'une rangée d'une matrice mémoire DRAM selon la présente invention ;
la figure 3 est une vue en coupe schématique d'une portion d'un mode de réalisation sous forme monolithique d'une rangée d'une matrice mémoire DRAM ; et
la figure 4 une vue en coupe schématique d'une portion d'un mode de réalisation sous forme monolithique de condensateurs de découplage selon la présente invention.

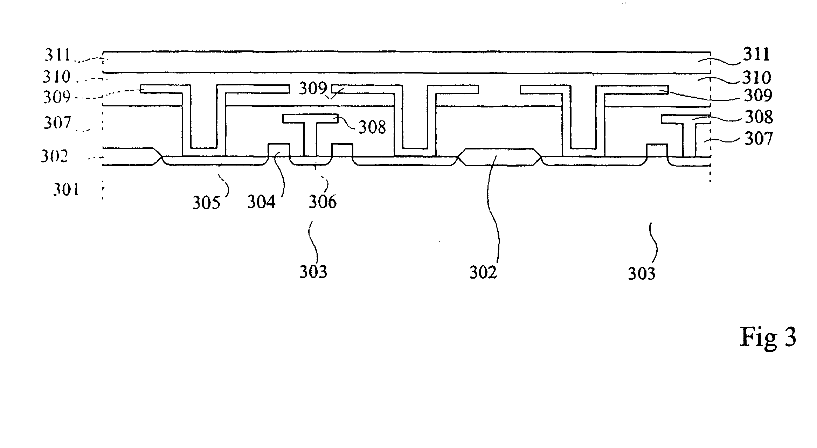

Les mêmes éléments ont été désignés par les mêmes références aux différentes figures. Pour des raisons de clarté, seuls les éléments nécessaires à la compréhension de l'invention ont été représentés et seront décrits par la suite. De plus, comme cela est classique dans le domaine de la représentation des circuits intégrés, les figures 3 et 4 ne sont pas tracées à l'échelle mais leurs dimensions ont été arbitrairement dilatées pour améliorer la lisibilité des dessins.

Une caractéristique de la présente invention est de stabiliser les alimentations d'une électrode commune des éléments mémoire à l'aide de plusieurs condensateurs de découplage.

La figure 2 représente le schéma équivalent d'une rangée de cellules DRAM d'une matrice mémoire à n rangées et n colonnes selon l'invention.

Une telle rangée comprend, comme une rangée classique (figure 1), n cellules mémoire. Chaque cellule comporte un condensateur C1, Cn, dont une première électrode est reliée au drain d'un transistor MOS de commande respectif M1, Mn et dont une deuxième électrode est commune aux n éléments. Les transistors M1, Mn sont connectés et représentés en figure 2 de la même façon que les éléments de mêmes références de la figure 1.

La rangée de mémoire selon l'invention est associée à trois condensateurs Cd1, Cd2 et Cd3 connectés en triangle. Le condensateur Cd1 est connecté entre l'électrode commune des éléments mémoire C1, Cn et la masse. Le condensateur Cd2 est connecté entre l'électrode commune des éléments mémoire C1, Cn et une alimentation d'écriture à Vdd. Le condensateur Cd3 est connecté entre la masse et l'alimentation à Vdd.

L'électrode commune des éléments mémoire C1, Cn, et donc également une électrode du condensateur Cd1 et une électrode du condensateur Cd2, est également connectée à une alimentation stable V, par, exemple identique à l'alimentation de précharge à Vdd/2 décrite précédemment.

Les condensateurs Cd1, Cd2 et Cd3 selon la présente invention assurent chacun une fonction de découplage qui sera détaillée ci-après.

La présente invention s'applique plus particulièrement aux mémoires qui, réalisées sous forme monolithique, comportent une électrode commune aux n cellules d'une rangée sensiblement plane, quel que soit le mode de réalisation des autres éléments (transistors MOS de commande, premières électrodes, etc.).

La figure 3 illustre, vu en coupe schématique, un mode de réalisation d'une telle mémoire sur un substrat semiconducteur 301. Sur le substrat 301, typiquement en silicium, des régions d'oxyde de champ épais 302 délimitent des zones actives 303. Chaque zone active 303 comporte une paire de transistors MOS comportant une grille isolée 304 et des régions de source 305 et de drain 306. Les transistors MOS d'une paire donnée ont une région de drain 306 commune. Une couche isolante 307, typiquement en oxyde de silicium, recouvre ces transistors ainsi que des contacts 308 de la région de drain 306. Les éléments mémoire sont des structures de condensateur comportant une première électrode 309 constituée d'un pied évidé, en contact avec la région de source 305 d'un transistor MOS, et d'un plateau sensiblement horizontal. Les condensateurs mémoire comportent également un diélectrique très mince (non représenté), et une deuxième électrode commune aux n condensateurs d'une rangée. La deuxième électrode est, par exemple, constituée d'une couche conductrice continue 310, par exemple, en silicium polycristallin, et d'une première couche métallique continue 311, par exemple en tungstène. On notera que les couches 310 et 311 sont électriquement confondues. La partie supérieure de cette deuxième électrode est sensiblement plane.

Selon la présente invention, toute mémoire dont les rangées comportent une électrode commune sensiblement plane, par exemple, similaire à celle de la figure 3, sera complétée de la façon décrite ci-après en relation avec la figure 4.

La figure 4 illustre, vue en coupe schématique, une portion de la réalisation sous forme monolithique des condensateurs de découplage d'une rangée de mémoire selon la présente invention.

La rangée de mémoire selon l'invention comporte une deuxième électrode 311 classique, sensiblement plane, commune aux n cellules de la rangée. Une couche isolante 312, par exemple en oxyde de silicium, recouvre l'électrode 311.

Selon l'invention, la couche isolante 312 est recouverte d'éléments conducteurs 313-1 et 313-2 distincts et alternés. Les éléments 313-1 et 313-2 sont formés par dépôt et gravure d'une couche conductrice, de préférence métallique, par exemple en aluminium. Les éléments conducteurs sont, de préférence, revêtus d'une couche isolante, de préférence planarisée, au-dessus de laquelle sont formés d'autres niveaux conducteurs (non représentés).

Selon l'invention, les éléments 313-1 sont polarisés au potentiel de référence (masse) du circuit et les éléments 313-2 sont polarisés au potentiel haut Vdd. On forme ainsi les condensateurs Cd1, Cd2 et Cd3 de la figure 2. Le condensateur Cd1 est formé entre la deuxième électrode 311 et les éléments 313-1. Le condensateur Cd2 est formé entre la deuxième électrode 311 et les éléments 313-2. Le condensateur Cd3 a pour première et deuxième électrodes les éléments 313-1 et 313-2, respectivement. Le diélectrique de chacun de ces condensateurs est constitué de la couche isolante 312.

La capacité de chacun des condensateurs Cd1, Cd2 et Cd3 est fixée par la nature et la dimension des éléments 313-1 et 313-2. En pratique, on notera qu'il faut que l'espacement entre deux éléments 313-1 et 313-2 soit inférieur à l'espacement entre ces éléments et la couche conductrice 311, pour que la capacité du condensateur Cd3 soit suffisamment élevée.

Un avantage de la présente invention est de protéger, par les condensateurs Cd1 et Cd3, les alimentations de la première électrode Vdd et V de sauts de courant.

Un autre avantage de la présente invention est de protéger, par le condensateur Cd2, les alimentations Vdd et V l'une par rapport à l'autre.

Un autre avantage de la présente invention est de prévoir de tels condensateurs Cd1, Cd2 et Cd3 dont la capacité est parfaitement connue. En effet, leurs capacités sont fixées par les rapports de surface de chacune de leurs électrodes et l'épaisseur des diélectriques les séparant ainsi que les caractéristiques des matériaux les constituant, au contraire de la capacité du condensateur parasite naturel Ceq dont la valeur varie en fonction de l'état programmé ou non des autres cellules mémoire de la matrice.

On notera que, pour un réseau mémoire de 1024 rangées par 1024 colonnes, la capacité du condensateur équivalent Ceq, de l'ordre de 62 pF, est négligeable devant la capacité du condensateur Cd1, de l'ordre de 145 pF.

Selon un mode de réalisation de l'invention, les éléments 313-1 et 313-2 ont une surface de 1,55 µm par 2,8 µm pour une couche isolante 312 de 9 µm, la capacité du condensateur Cd1 est sensiblement de 145 pF, la capacité du condensateur Cd2 est sensiblement de 166 pF et la capacité du condensateur Cd3 est sensiblement de 166 pF.

Bien entendu, la présente invention est susceptible de diverses variantes et modifications qui apparaîtront à l'homme de l'art. En particulier, la nature et les dimensions des éléments 313-1 et 313-2 constituant le plan conducteur selon l'invention peuvent être modifiés pour modifier la valeur des capacités des condensateurs de découplage. Par exemple, les capacités des condensateurs Cd1 et Cd3 pourront être différentes. De plus, la structure des divers éléments constituant la mémoire peut être quelconque, pour autant que les condensateurs mémoire comportent une deuxième électrode supérieure sensiblement plane. De plus, bien que la présente invention ait été illustrée à l'aide d'une matrice mémoire carrée de n rangées et n colonnes, elle s'applique à toute matrice mémoire de n rangées, m colonnes, quels que soient n et m.

## Revendications

1. Mémoire dynamique à accès aléatoire réalisée sous forme monolithique dont les cellules (1, n) comportent chacune un transistor MOS (M1, Mn) et un condensateur (C1, Cn) dont une deuxième électrode (311) est commune à toutes les cellules d'une même rangée et est recouverte d'un isolant (312), **caractérisée en ce que** l'isolant est revêtu d'éléments conducteurs indépendants (313-1, 313-2) répartis sur un même plan horizontal, deux éléments voisins (313-1, 313-2) étant polarisés à des niveaux respectifs haut et bas.

2. Mémoire selon la revendication 1, **caractérisée en ce que** le potentiel bas est le potentiel de référence du circuit dans lequel est formée la cellule.

3. Mémoire selon l'une des revendications 1 ou 2, **caractérisée en ce que** le potentiel haut est le potentiel d'écriture de la cellule mémoire (Vdd).

## Patentansprüche

1. Ein monolithisches DRAM, wobei jede Zelle (1, n) desselben einen MOS-Transistor (M1, Mn) und einen Kondensator (C1, Cn) aufweist, und wobei eine zweite Elektrode (311) desselben für alle Zellen der gleichen Zeile gemeinsam ist und mit einem Isolator (312) bedeckt ist, **dadurch gekennzeichnet, dass** der Isolator mit unabhängigen leitenden Elementen (313-1, 313-2) verteilt auf einer gleichen Horizontalebene beschichtet ist, wobei zwei benachbarte Elemente (313-1, 313-2) auf hohe bzw. niedrige Pegel vorgespannt sind.

2. Der Speicher nach Anspruch 1, **dadurch gekennzeichnet, dass** das niedrige Potential das Referenzpotential der Schaltung ist in der die Zelle geformt ist.

3. Der Speicher nach Anspruch 1 oder 2, **dadurch gekennzeichnet, dass** das hohe Potential das Schreibpotential der Speicherzelle (Vdd) ist.

## Claims

1. A monolithic DRAM, each cell (1, n) of which includes a MOS transistor (M1, Mn) and a capacitor (C1, Cn), a second electrode (311) of which is common to all cells of a same row and is covered with an insulator (312), **characterized in that** the insulator is coated with independent conductive elements (313-1, 313-2) distributed on a same horizontal plane, two neighboring elements (313-1, 313-2) being biased to respective high and low levels.

2. The memory of claim 1, **characterized in that** the low potential is the reference potential of the circuit in which the cell is formed.

3. The memory of claim 1 or 2, **characterized in that** the high potential is the write potential of the memory cell (Vdd).
